# EUROPEAN PATENT APPLICATION

(11) **EP 3 975 277 A1**
(43) Date of publication of application: **30.03.2022**
(21) Application number: 20306089.2
(22) Date of filing: 24.09.2020
(51) Int. Cl.: H01L 51/00, H01L 51/48

(54) **PROCESS FOR PREPARING A DISPERSION OF NON-STOECHIOMETRIC NICKEL OXIDE NANOPARTICLES IN ALCOHOL**

(71) Applicant: Universite d'Aix-Marseille, 13007 Marseille (FR); Centre national de la recherche scientifique, 75016 Paris (FR)
(72) Inventor: MARGEAT, Olivier, 13008 MARSEILLE (FR); AKERMANN, Jorg, 13008 MARSEILLE (FR); ALKARSIFI, Riva, 36000 Pessac (FR)
(74) Representative: Cabinet Becker et Associés

(57) **Abstract**

The invention relates to a process for preparing a dispersion of NiOₓ nanoparticles in alcohol. It also relates to a process for preparing an organic solar cell, in particular an inverted organic solar cell, using such dispersion.

## Description

### TECHNICAL FIELD

The invention relates to a process for preparing a dispersion of NiOₓ nanoparticles in alcohol. It also relates to a process for preparing an organic solar cell, in particular an inverted organic solar cell, using such dispersion.

### TECHNICAL BACKGROUND

A typical structure of printed organic solar cells (OSCs) consists of a multilayer stack based on several layers printed on top of each other. In a normal device structure, a hole extraction layer (or hole transport layer, HTL) is deposited on top of a transparent electrode followed by the successive deposition of a photoactive layer and an electron-extraction layer (or electron transport layer, ETL), and the final layer is an electrode deposited on top of the ETL. In an inverted device structure, the ETL and the HTL are switched: ETL is deposited on top of the transparent electrode followed by the photoactive layer and HTL, and the electrode is deposited on top of the HTL. The photoactive layer usually consists of a blend of a polymeric donor mixed with an acceptor, which is usually a fullerene derivative. Recently, novel non-fullerene acceptors have also been developed to improve the performances of solar cells.

Nowadays, high efficiencies are obtained using poly(3,4-ethylenedioxythiophene):sodium polystyrene sulfonate (PEDOT:PSS) as a HTL in the normal device structure. However, this product is highly hydrophilic and consequently, a poor film morphology, in particular a high roughness, and electrical properties are observed when water-based PEDOT:PSS solutions are deposited onto the hydrophobic photoactive layer in the inverted device structure. Wagner et al. (Synth. Met. 2013, 181, 64-71) have shown that the use of proper additives capable of reducing the hydrophilic nature of PEDOT:PSS, for example Triton X-100, could improve HTL quality, and power conversion efficiencies (PCE) over 7 % could be reached with fullerene-based polymer blends. However, the presence of water and additives in the ink used for printing the HTL causes issues, in particular in the robustness of the printing process and the compatibility with the recent non-fullerene acceptor materials.

To replace PEDOT:PSS as a HTL, non-stoichiometric nickel oxide (NiOₓ) is a well-known and promising material. The wide band gap of NiOₓ and its high ionization potential promote an Ohmic contact at the BHJ (Barret Joyner Halenda)/anode interface. Since the valence band is around 5.0-5.4 eV and the conduction band is around 1.8 eV, which is higher than the LUMO level of the donor, NiOₓ efficiently collects holes from the donor phase (selective to holes) and is effective in blocking electrons. NiOₓ appears as a well-suited material for anode modification due to its good optical transparency, high chemical stability, electron-blocking ability and favorable energy level alignment with the donor materials in organic solar cells.

Wallace et al. (Adv. Mater. 2015, 27, 2930-2937) describe a water-based NiOₓ nanoparticles dispersion and its use for forming an HTL in a normal OSC. However, such a water-based dispersion cannot be applied to an inverted OSC, due to the above-discussed wettability and compatibility issues.

Due to their solubility, viscosity, surface tension, and volatility properties, alcohols, and more particularly C₁-C₄ alcohols such as isopropanol or ethanol, appear to be a suitable solvent for replacing water in NiOₓ nanoparticles dispersions. However, there exists no process for preparing a stable NiOₓ nanoparticles dispersion in such solvent. Hence, there remains a need to develop a process for preparing an alcohol-based dispersion of NiOₓ nanoparticles.

### SUMMARY OF THE INVENTION

In this respect, the inventors have shown that an alcohol-based dispersion (or "ink") of NiOₓ nanoparticles could be prepared by a simple process comprising two dispersing steps separated by a centrifuging step. It was demonstrated that the presence of water, alcohol, and methoxy-acetic acid as a surfactant in the first dispersing step, and the use of ultrasonication in both dispersing steps were crucial to obtain a highly stable and aggregate-free dispersion in alcohol. The ink obtained by the process of the invention was deposited onto the photoactive layer of an inverted OSC to successfully form a NiOₓ-based HTL layer. Interestingly, the inventors have also shown that such ink could also be used for preparing a normal OSC.

Thus, the present invention relates to a process for preparing an alcohol-based dispersion of NiOₓ nanoparticles (also named herein "NiOx process"), said process comprising the following steps:
(a) dispersing NiOₓ nanoparticles in a 50:50 (v/v) to 90:10 (v/v) alcohol/water mixture in the presence of methoxy-acetic acid, under ultrasonication for 1h to 3h;
(b) centrifuging the dispersion obtained in step (a) so as to recover a precipitate containing NiOₓ nanoparticles;
(c) dispersing the precipitate obtained in step (b) in alcohol and under ultrasonication for 1h to 4h;
(d) optionally filtering the dispersion obtained in step (c); and
(e) recovering an alcohol-based dispersion of NiOₓ nanoparticles;
wherein ultrasonication in each of steps (a) and (c) is carried out by means of an ultrasonication device, with a power of ultrasonication from 0.05 to 20 W/(D x S), where D is the surface of the horn of the ultrasonication device in cm² and S is the volume of the dispersion in mL.

The present invention also relates to a process for preparing an inverted organic solar cell (also named herein "iOSC process"), said process comprising the following steps:
(i) providing a multi-layer assembly comprising a photoactive layer, an electron-transport layer, and a transparent electrode, wherein said electron-transport layer is comprised between said transparent electrode and said photoactive layer;
(ii) depositing an alcohol-based dispersion of NiOₓ nanoparticles obtained by a process as defined herein, onto said photoactive layer, under conditions allowing to obtain a NiOₓ-based hole-transport layer;
(iii) optionally depositing at least one organic dopant layer onto said NiOₓ-based hole-transport layer; and
(iv) depositing an anode onto the assembly obtained in step (ii) or (iii), so as to obtain an inverted organic solar cell.

The present invention further relates to a process for preparing a normal organic solar cell (also named herein "nOSC process") comprising:
(i') depositing an alcohol-based dispersion of NiOₓ nanoparticles obtained by a process as defined herein, onto a transparent electrode, under conditions allowing to obtain a NiOₓ-based hole-transport layer;
(ii') optionally depositing at least one organic dopant layer onto said NiOₓ-based hole-transport layer;
(iii') depositing successively a photoactive layer and an electron-transport layer, onto the assembly obtained in step (i') or (ii'); and
(iv') depositing a cathode onto the assembly obtained in step (iii'), so as to obtain a normal organic solar cell.

### BRIEF DESCRIPTION OF THE FIGURES

**Figure 1****:** TEM images of non-stochiometric (a) pristine NiOₓ and (b) Cu-NiOₓ (12.2%) nanoparticles with scale bar of 50 nm.
**Figure 2****:** (a) XRD diffractograms and (b) XPS spectra of the pristine NiOₓ and the Cu-NiOₓ (12.2%) films.
**Figure 3****:** DLS measured size distribution by number for a 10 mg/mL Cu-NiOₓ(12.2%) (a) in a 0.8:0.2 isopropanol/water solution comprising MAA, dispersed using different ultrasonic treatments and (b) the resulting isopropanol-based dispersions prepared using a probe ultrasonication for 2 hours.
**Figure 4****:** Scheme of the architecture of the normal (left) and inverted device structure (right).
**Figure 5****:** AFM images of the Cu-NiOₓ (12.2%) films deposited on ITO substrates from (a) 10 mg/mL, (b) 20 mg/mL, and (c) 30 mg/mL isopropanol solutions.
**Figure 6****:** AFM images of (a) water-based Cu-NiOₓ (12.2%) and (b) isopropanol-based Cu-NiOₓ (12.2%) films deposited on top of PTB7:PC70BM layer.
**Figure 7****:** Optical transmission spectra of the 40 nm thick- NiOₓ and Cu-NiOₓ films deposited from isopropanol solutions on glass substrates.
**Figure 8****:** The J-V curves of the PBDB-T-2F:IT-4F-based inverted device structures using MoO₃ films and [Cu-NiOₓ 12.2 % + F4TCNQ] films.

### DETAILED DESCRIPTION OF THE INVENTION

As used herein, the term "NiOₓ" refers to a non-stochiometric nickel oxide. More particularly, "NiOₓ" refers to a formula representing the non-stochiometric nickel oxide, wherein x may be comprised between 0.8 and 1.

The term "nanoparticle" refers to a particle having a nanometric size, in particular having a mean diameter equal to or less than 100 nm, preferably a mean diameter between 1 nm to 100 nm, more preferably between 3 nm and 20 nm.

The standard deviation of nanoparticles diameters is advantageously less than or equal to 25%, preferably less than or equal to 20%. The distribution of nanoparticle diameters may be unimodal or multimodal, preferably unimodal. The mean diameter of the nanoparticles, standard deviation and diameters distribution can be determined, in particular, by statistical studies of microscopy images, for example, those generated by scanning electron microscopy (SEM) or transmission electron microscopy (TEM).

In the NiOx process, NiOₓ nanoparticles are first dispersed in an alcohol/water mixture in the presence of a surfactant, namely methoxy-acetic acid (MAA), and under ultrasonication (step (a)).

In a particular embodiment, said alcohol in step (a) is an alcohol having 1 to 4 carbon atoms (also noted "C₁-C₄ alcohol"), such as methanol, ethanol, propanol, isopropanol, butanol, isobutanol, or a mixture thereof. Preferably, said alcohol is ethanol or isopropanol, more preferably said alcohol is isopropanol.

In a particular embodiment, the mean diameter of the NiOₓ nanoparticles used in step (a) is comprised between 1 nm and 100 nm, preferably between 3 nm and 20 nm. NiOₓ nanoparticles are preferably crystalline. The expression "NiOₓ nanocrystals" may be used to denote crystalline NiOₓ nanoparticles.. The shape of the NiOₓ nanoparticles is not particularly limited. For instance, the NiOₓ nanoparticles may be spherical or nearly spherical.

Such NiOₓ nanoparticles can be prepared by any process known to the skilled artisan. For instance, the NiOₓ nanoparticles can be prepared starting from a nickel salt. The nickel salt can be dispersed in water, and a hydroxide can be added so as to reach a basic pH, preferably between 9 and 12 (more preferably, around 10). The precipitate obtained can then be isolated by any suitable technique (preferably, centrifugation), and dried at a suitable temperature (preferably, a temperature between 70°C and 100°C). Finally, the dried precipitate can be calcined at a suitable temperature (preferably, between 200°C and 350 °C, more preferably between 250°C and 300 °C). A grinding step can advantageously be carried out after drying and before calcinating the precipitate.

Examples of nickel salts include, but are not limited to, nickel nitrate, nickel chloride, nickel bromide, nickel sulfate, and hydrates thereof, preferably nickel nitrate or a hydrate thereof. Examples of hydroxide include, but are not limited to, potassium hydroxide and sodium hydroxide, preferably sodium hydroxide.

In a particular embodiment, NiOₓ nanoparticles comprise a dopant.

The dopant may be any chemical element. Preferably, the dopant is a metal. For instance, the dopant may be tin, lithium, copper, cobalt, strontium, iron, nickel, silver, gold, palladium, rhodium, iridium, platinum, indium, and lanthanides such as ytterbium or cerium, aluminum, lead, silicon, germanium, or a mixture thereof.

In a particular embodiment, the dopant is a metal selected from the group consisting of copper, tin, lithium, or a mixture thereof. Preferably, the dopant is copper.

In a particular embodiment, the dopant concentration is comprised between 1 % at. and 40 % at., preferably between 2 % at. and 20 % at. "% at" refers to the percentage of the molar amount of dopant to the molar amount of nickel Ni from NiOₓ nanoparticles.

The expression "M-NiOₓ (Y%)" refers to NiOₓ nanoparticles comprising Y % at. of M as a dopant.

The dopant may in particular be inserted when preparing NiOₓ nanoparticles. For instance, a salt of the dopant can be used in combination with the nickel salt used for preparing NiOₓ nanoparticles. In an embodiment where the dopant is copper, the copper salt may be copper nitrate, copper sulfate, copper chloride, copper iodide, copper tetrafluoroborate, or a hydrate thereof, preferably copper nitrate or a hydrate thereof.

In step (a) of the NiOx process, the alcohol/water mixture is a 50:50 (v/v) to 90:10 (v/v) alcohol/water mixture, preferably a 70:30 (v/v) to 85:15 (v/v) alcohol/water mixture, more preferably a 75:25 (v/v) to 85:15 (v/v) alcohol/water mixture.

In a particular embodiment, the weight ratio of the methoxy-acetic acid to the NiOₓ nanoparticles in step (a) is comprised between 0.5 and 2, preferably between 0.6 and 1.8, more preferably between 0.6 and 1.5, and even more preferably between 0.6 and 0.9.

The concentration of the NiOₓ nanoparticles in the alcohol/water mixture in step (a) may be comprised between 0.1 mg/mL and 100 mg/mL, preferably between 5 and 40 mg/mL.

The dispersing step (a) is carried out under ultrasonication, for 1 hour to 3 hours, for instance for 1 hour to 2 hours, or for 2 hours to 3 hours.

The ultrasonication can be carried out by means of any ultrasonication device which is able to deliver the required power. In a preferred embodiment, the ultrasonication device is a ultrasonication probe.

The power of ultrasonication in step (a) is from 0.05 to 20 W/(D x S), where D is the surface of the horn of the ultrasonication device in cm² and S is the volume of the dispersion in mL. In a particular embodiment, the power of ultrasonication in step (a) is from 0.1 to 10 W/(D x S), preferably from 0.5 to 2 W/(D x S), where D and S are as defined herein.

As used herein, the "horn" refers to the part of the ultrasonication device from which ultrasounds are emitted or amplified. The horn may typically be a metallic part, having any shape, such as a metallic rod or cylinder. The surface D of the horn corresponds to the surface in contact with the mixture, solution or dispersion, subjected to ultrasonication.

The power of ultrasonication (in W/(cm².mL)) is determined by the power of the ultrasonication device (in W), the horn surface of the ultrasonication device (D, in cm²), and the volume of the dispersion (S, in mL). These three parameters can therefore be adjusted by the skilled artisan so as to reach a power of ultrasonication within the above ranges.

For instance, a power of ultrasonication of 1 W/(cm².mL) can be obtained by using a 50 W ultrasonication device having a horn surface (D) of 10 cm² in a mixture of 5 mL.

In a particular embodiment, the surface of the horn (D) is comprised between 1 cm² and 100 cm², preferably between 2 cm² and 20 cm².

In another particular embodiment, the volume of the dispersion (S) is comprised between 0.5 mL and 2000 mL, preferably between 1 and 10 mL.

In yet another embodiment, the power of the ultrasonication device is comprised between 10 W and 4000 W, preferably between 20 W and 200 W.

The dispersing step (a) may be carried out at room temperature. As used herein, "room temperature" refers to a temperature comprised between 5 °C and 50 °C, preferably between 15 °C and 35 °C, and more preferably between 18 °C and 25 °C.

Step (b) of the process of the invention comprises centrifuging the dispersion obtained in step (a), so as to recover a precipitate containing NiOₓ nanoparticles.

Conditions of the centrifugation, such as its duration and its rate, can be judiciously chosen by the skilled artisan. For instance, said centrifuging step can be carried out for 1 min to 1 hour, preferably for 10 min to 30 min, preferably at a rate comprised between 2000 rpm and 20 000 rpm, more preferably between 5000 and 10 000 rpm. Typically, centrifuging step (b) produces a precipitate containing NiOₓ nanoparticles, and a liquid supernatant. The precipitate containing NiOₓ nanoparticles can be recovered by any suitable technique known to the skilled artisan, such as filtration, or evaporation.

Advantageously, the conditions of step (b) are chosen such that the precipitate containing NiOₓ nanoparticles obtained after the centrifuging step (b) is not dry.

In a preferred embodiment, step (b) is performed under conditions allowing to recover a precipitate having a dry matter content of 95 to 99.9%.

In another preferred embodiment, the water content of the dispersion obtained in step (a) is removed from 95% to 99.9% in step (b).

Step (c) of the process of the invention comprises dispersing the precipitate containing NiOₓ nanoparticles obtained in step (b) in alcohol and under ultrasonication for 1h to 4h, preferably for 1.5h to 3h.

In a particular embodiment, said alcohol in step (c) is an alcohol having 1 to 4 carbon atoms (also noted "C₁-C₄ alcohol"), such as methanol, ethanol, propanol, isopropanol, butanol, isobutanol, or a mixture thereof. Preferably, said alcohol is ethanol or isopropanol, more preferably said alcohol is isopropanol.

Said alcohols in steps (a) and (c) may be identical or different, preferably said alcohols are identical.

The power of ultrasonication in step (c) is from 0.05 to 20 W/(D x S), where D is the surface of the horn of the ultrasonication device in cm² and S is the volume of the dispersion in mL. In a particular embodiment, the power of ultrasonication in step (c) is from 0.1 to 10 W/(D x S), preferably from 0.5 to 2 W/(D x S), where D and S are as defined herein.

Generally speaking, the particular and preferred embodiments relating to the ultrasonication in step (a) apply to ultrasonication in step (c). The conditions of ultrasonication in step (a) and those in step (c) may be identical or different.

The dispersing step (c) may be carried out at room temperature.

Step (c) produces a dispersion of NiOₓ nanoparticles in alcohol. Optionally, said dispersion can be filtered (step d), in particular, so as to remove traces of solid residues present in the dispersion. Filters made of PTFE (polytetrafluoroethylene) having a suitable porosity may be used in such step (d). A highly stable and aggregate-free dispersion of NiOₓ nanoparticles in alcohol is thereby recovered in step (e) of the NiOx process. Said dispersion can be stable for several months, for instance, from 1 month to 6 months.

In particular, the mean diameter of the NiOₓ nanoparticles in the dispersion prepared by the process of the invention can be comprised between 1 nm and 100 nm, preferably between 3 nm and 20 nm.

The concentration of the NiOₓ nanoparticles in said dispersion is substantially identical to that of the NiOₓ nanoparticles in the alcohol/water mixture of step (a).

The present invention also relates to a process for preparing an inverted organic solar cell, said process comprising the following steps:
(i) providing a multi-layer assembly comprising a photoactive layer, an electron-transport layer, and a transparent electrode, wherein said electron-transport layer is comprised between said transparent electrode and said photoactive layer;
(ii) depositing an alcohol-based dispersion of NiOₓ nanoparticles obtained by the NiOx process as defined above, onto said photoactive layer, under conditions allowing to obtain a NiOₓ-based hole-transport layer;
(iii) optionally depositing at least one organic dopant layer onto said NiOₓ-based hole-transport layer; and
(iv) depositing an anode onto the assembly obtained in step (ii) or (iii), so as to obtain an inverted organic solar cell.

The present invention further relates to a process for preparing a normal organic solar cell comprising:
(i') depositing an alcohol-based dispersion of NiOₓ nanoparticles obtained by a process as defined herein, onto a transparent electrode, under conditions allowing to obtain a NiOₓ-based hole-transport layer;
(ii') optionally depositing at least one organic dopant layer onto said NiOₓ-based hole-transport layer;
(iii') depositing successively (in the following order): a photoactive layer and an electron-transport layer, onto the assembly obtained in step (i') or (ii'); and
(iv') depositing a cathode onto the assembly obtained in step (iii'), so as to obtain a normal organic solar cell.

Typically, the photoactive layer is organic, in particular polymeric, and hydrophobic. More particularly, the photoactive layer may be a combination of a polymer donor with a fullerene or non-fullerene acceptor. Examples of photoactive layers which can be used for preparing organic solar cells are described by Lu et al. (Chem. Rev. 2015, 115, 12666-12731).

In a particular embodiment, the photoactive layer is chosen from PTB7:PC70BM, PBDB-T-2F:IT-4F, and PCE-13:IT-4F.

"PTB7" means "poly [[4,8-bis[(2-ethylhexyl)oxy]benzo[1,2-b:4,5-b']dithiophene-2,6-diyl][3-fluoro-2-[(2-ethylhexyl)carbonyl]thieno[3,4-b]thiophenediyl]]".

"PBDB-T-2F" (also named "PBDB-TF" or "PM6") means "poly[(2,6-(4,8-bis(5-(2-ethylhexyl-3-fluoro)thiophen-2-yl)-benzo[1,2-b:4,5-b']dithiophene))-alt-(5,5-(1',3'-di-2-thienyl-5',7'-bis(2-ethylhexyl)benzo[1',2'-c:4',5'-c']dithiophene-4,8-dione)]".

"PCE-13" (also named "PBDB-TSF") means "poly[(2,6-(4,8-bis(5-(2-ethylhexylthio)-4-fluorothiophen-2-yl)-benzo[1,2-b:4,5-b']dithiophene))-alt-(5,5-(1',3'-di-2-thienyl-5',7'-bis(2-ethylhexyl)benzo[1',2'-c:4',5'-c']dithiophene-4,8-dione)]"

"PC70BM" (also named "C70 PCBM" or "PC71BM") means "[6,6]-phenyl-C71-butyric acid methyl ester".

"IT-4F" (also named "ITIC-F" or "ITIC-DF") means "3,9-bis(2-methylene-((3-(1,1-dicyanomethylene)-6,7-difluoro)-indanone))-5,5,11,11-tetrakis(4-hexylphenyl)-dithieno[2,3-d:2',3'-d']-s-indaceno[1,2-b:5,6-b']dithiophene".

The transparent electrode may for instance be an indium tin oxide (ITO), fluorine-doped tin oxide (FTO), or aluminum-doped tin oxide (AZO) electrode.

The electron-transport layer may for instance be a zinc oxide (ZnO), AZO, titanium oxide (TiO₂), polyethyleneimine (PEIE), poly [(9,9-bis(3'-(N,N-dimethylamino)propyl)-2,7-fluorene)-alt-2,7-(9,9-dioctylfluorene)] (PFN) layer.

In the above processes, an organic dopant may be deposited onto said NiOₓ-based hole-transport layer. Such organic dopant may be used to enhance the work function of the NiOₓ-based hole-transport layer. Examples of organic dopants include, but are not limited to, tetracyanoquinodimethane (TCNQ), 2-fluoro-7,7,8,8-tetracyanoquinodimethane (FTCNQ), 2,5-difluoro-tetracyanoquinodimethane (F2TCNQ), 2,3,5,6-tetrafluoro-7,7,8,8-tetracyanoquinodimethane (F4TCNQ), 1,3,4,5,7,8-hexafluoro-tetracyanonaphthoquinodimethane (F6TCNNQ), or molybdenum tris(1-(trifluoroacetyl)-2-(trifluoromethyl)ethane-1,2-dithiolene) (Mo(tdf-COCF3)3). In a preferred embodiment, the at least one organic dopant layer is F4TCNQ.

In iOSC process, the anode is preferably a silver electrode.

In nOSC process, the cathode is preferably an aluminum electrode.

The multi-layer assembly provided in step (i) of the iOSC process can be prepared by any suitable technique known to the skilled artisan. In particular, said multi-layer assembly may be formed by successive film-depositions, wherein each deposition is carried out by spin-coating.

Similarly, the depositing steps (ii), (iii), (iv), (i') (ii'), (iii'), and (iv') can be each independently carried out by any suitable film-deposition technique known to the skilled artisan, such as spin-coating or thermal evaporation.

The conditions of each depositing step, for instance the concentration of the solutions or dispersions to be deposited, the rate and time of spin-coating, or the pressure of the thermal evaporation, can be determined by the skilled artisan.

In a particular embodiment, depositing steps (ii), (iii), (i'), (ii'), and (iii') are carried out by spin-coating. Preferably, depositing steps (ii), (iii), (i'), (ii'), and (iii') are each independently carried out by spin-coating at a rate comprised between 1000 and 8000 rpm, and for 30 s to 5 min.

In another particular embodiment, depositing steps (iv) and (iv') are carried out by thermal evaporation, preferably at a pressure comprised between 6.10⁻⁵ Pa and 6.10⁻⁴ Pa, and a temperature comprised between 20 °C and 140 °C.

Each depositing step, in particular when depositing is carried out by spin-coating, may further comprise a step of heating of the film obtained by said deposition.

Each of steps (ii) and (i') comprises depositing said alcohol-based dispersion of NiOₓ nanoparticles, and advantageously, further comprises heating of the film obtained by said deposition.

Each of optional steps (iii) and (ii') comprises depositing at least one organic dopant layer onto said NiOₓ-based hole-transport layer, and advantageously, further comprises heating of the film obtained by said deposition.

Heating in steps (ii), (i'), (iii) and (ii') may independently be carried out at a temperature comprised between 50°C and 120 °C, preferably for 5 minutes to 2 hours.

In a particular embodiment, the thickness of the NiOₓ-based hole-transport layer obtained in steps (i') or (ii) is comprised between 12 nm and 80 nm, preferably between 15 nm and 50 nm.

In the above iOSC and nOSC processes, the alcohol of said alcohol-based dispersion of NiOₓ nanoparticles is advantageously an alcohol having 1 to 4 carbon atoms (also noted "C₁-C₄ alcohol"), such as methanol, ethanol, propanol, isopropanol, butanol, isobutanol, or a mixture thereof. Preferably, said alcohol is ethanol or isopropanol, more preferably said alcohol is isopropanol.

The invention will also be described in further detail in the following examples, which are not intended to limit the scope of this invention, as defined by the attached claims.

### EXAMPLES

### Material & Methods

The NiOx nanoparticles were characterized by HR-TEM (JEOL 3010, acceleration voltage of 300 kV). The samples were prepared by drop-casting a diluted isopropanol solution of NiOₓ nanoparticles onto a carbon-coated copper grid. Size distribution of the nanoparticles within the solution was determined by DLS using a NanoZetaSizer from Malvern. Crystallinity of the NiOₓ nanoparticles was measured by XRD using an INEL with a linear detector. AFM was realized using a NTEGRA Prima of the brand NT-MDT in taping mode to study the quality of the NiOₓ nanoparticles layers. Layer thicknesses were determined using a mechanical profilometer. Photoemission spectroscopy were performed using UV (UPS, HeI 21.2 eV) and X-ray (XPS, monochromatized Al Kα 1486.7 eV) light sources.

### Example 1. Process for preparing an isopropanol-based dispersion of NiOₓ nanoparticles

### a - Synthesis of NiOₓ nanoparticles

NiOₓ nanoparticles were prepared by a chemical precipitation method according to a previous report (F. Jiang, et al., Adv. Mater. Deerfield Beach Fla, 2015, 27, 2930-2937). Typically, 0.05 mole of Ni(NO₃)₂·6H₂O were dispersed in 100 mL deionized water. A dark green solution was obtained. Under continuous magnetic stirring, the pH of the solution was adjusted to 10 by the dropwise addition of 10 M NaOH aqueous solution. The pH value was measured by a pH meter (Hanna HI 8417 pH meter). After stirring for 10 minutes, the green colloidal precipitate was washed twice by deionized water using centrifugation and dried at 80 °C overnight. To ensure a complete calcination, the obtained green solid was ground to finer powder using a pestle and a mortar, then calcined at 270 °C for 2 hours to yield a black powder.

For the Cu-NiOₓ nanoparticles, the same procedure was followed. The only difference is the addition of the Cu(NO₃)₂.xH₂O precursor in the initial solution at various molar ratios (from 2 to 20%).

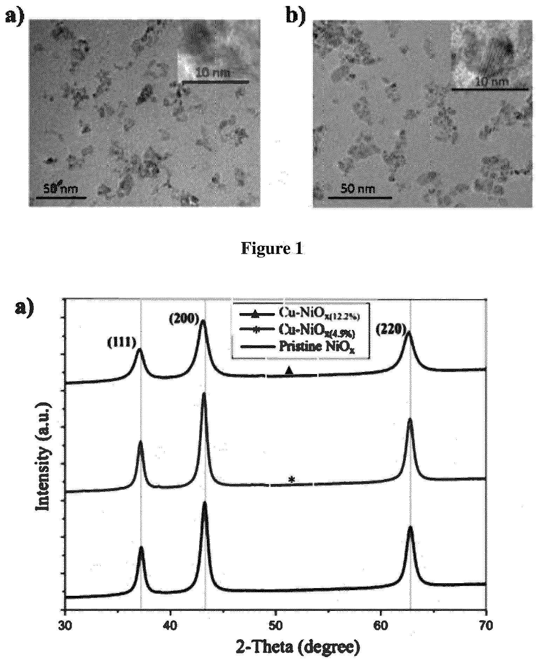

TEM images of non-stochiometric pristine NiOₓ and Cu-NiOₓ (12.2%) nanoparticles are shown in Figure 1 (a- pristine NiOx; b- Cu-NiOₓ (12.2%)).

X-Ray Diffraction (XRD) patterns of both pristine NiOₓ and Cu-doped NiOₓ nanoparticles are shown in Figure 2a. The diffraction peaks of the pristine NiOₓ nanoparticles revealed cubic crystal structure with three prominent characteristic diffraction peaks at 37.29°, 43.34°, and 62.91°, which could be assigned to (111), (200), and (220) planes of NiOₓ, respectively. No extra diffraction peaks related to metallic Cu or to copper oxide phase were observed in the XRD diffractogram of Cu-doped NiOₓ nanoparticles, indicating that doping with Cu could hardly change the phase structure of NiOₓ.

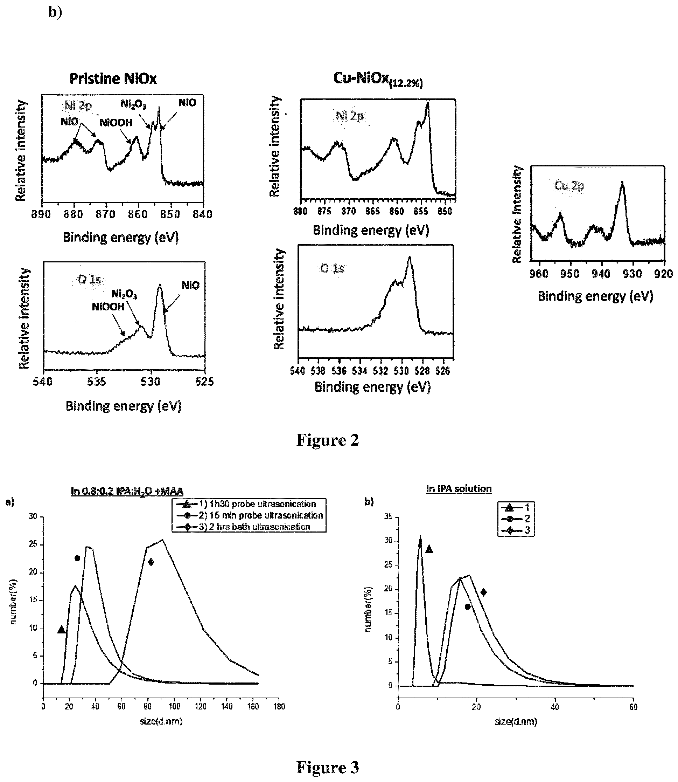

XPS spectra for the pristine NiOₓ and Cu-doped NiOₓ nanoparticles films are shown in Figure 2b. The Ni 2p_{3/2} level at 860 eV and the O 1s level at 532.2 eV correspond to the Ni³⁺ state of the NiOOH species. The Ni 2p_{3/2} level at 855 eV and the O 1s level at 531 eV peaks can be assigned to the Ni³⁺ state of the Ni₂O₃. In addition, the presence of the Ni²⁺ state of NiOₓ is revealed by the Ni 2p_{3/2} level at 853.6 and O 1s level at 529 eV peaks as well as the Ni 2p_{1/2} peak and its satellites at 873.6 and 878.5 eV. These results are in consistence with the XPS measurements of the previously synthesized NiOₓ nanoparticles (F. Jiang, et al., Adv. Mater. Deerfield Beach Fla, 2015, 27, 2930-2937). The coexistence of Ni²⁺ and Ni³⁺ states is a confirmation of the non-stoichiometric nature of the NiOₓ. The XPS spectra of the Cu-NiOₓ (12.2%) films proved that Cu atoms have been successfully incorporated into the NiOₓ nanoparticles due to the presence of two peaks located at 933.3 and 953.5 eV corresponding to Cu 2p3/2 and Cu 2p_{1/2} levels, respectively. These peaks revealed that Cu²⁺ ions substituted the Ni atom in the NiOx crystal lattice.

### b-Preparation of an isopropanol-based dispersion of NiOₓ nanoparticles

Typical procedure: NiOₓ nanoparticles were dispersed in S=5 mL of a 8:2 isopropanol:water mixture with 70% wt. methoxy acetic acid (6 µL for each 10 mg/mL NiOₓ). After 1.5h under ultrasonication (probe UP50H, 50W, D=10 cm²), the dispersion was centrifuged to obtain a wet precipitate, and the precipitate was re-dispersed in isopropanol under ultrasonication (probe UP50H, 50W, D=10 cm²) for 2h.

Figure 3a shows that subjecting the intermediate dispersion (namely, in 8:2 isopropanol:water mixture) to a ultrasonication probe of 50 W, with a horn surface (D) of 10 cm² for a volume (S) of 5 mL (dispersion n°1) resulted in less aggregates than a dispersion subjected to a classical bath ultrasonication (dispersion n°3), which has a very low power of ultrasonication, typically less than 0.05 W/cm²/mL. DLS measurements also showed that subjecting the intermediate dispersion to ultrasonication probe for 1.5h (dispersion n°1) resulted in less aggregates than a dispersion subjected to the same ultrasonication probe for 15 min (dispersion n°2).

Furthermore, Figure 3b shows that subjecting the intermediate dispersion n°1 to centrifugation and re-dispersion in isopropanol under ultrasonication (probe of 50 W, horn surface (D) of 10 cm², volume (S) of 5 mL) for 2 hours resulted in an aggregate-free dispersion. On the contrary, aggregates were obtained when a similar treatment was applied to intermediate dispersions n°2 and n°3.

### Example 2. Process for preparing an OSC and performances of the OSC

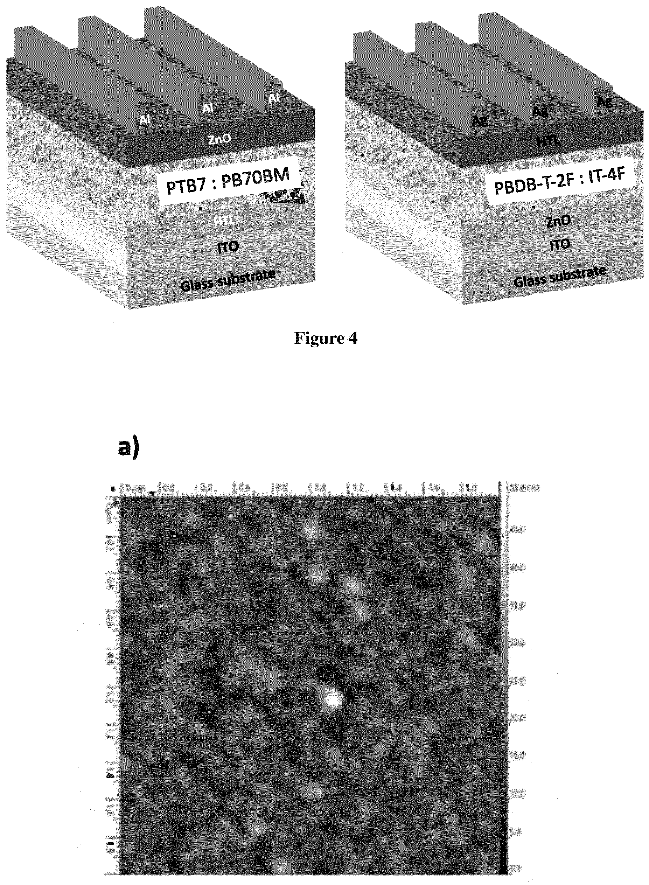

### Normal Device Structure (Figure 4 left)

First, ITO substrates (15 Ω sq⁻¹) were cleaned by deionized water, acetone, ethanol, and isopropanol with ultrasonication. Then, the pre-cleaned ITO substrates were exposed to UV-ozone treatment for 15 min to reform the surface.

PEDOT:PSS: a thin layer of PEDOT:PSS (Heraeus, CLEVIOS PVP AI 4083) was spin-coated on the pre-cleaned ITO substrate at a speed of 3500 rpm for 60 s followed by heating on a hotplate at 140 °C for 20 min to obtain a film thickness of ≈40 nm.

NiOx nanoparticles: the NiOₓ HTLs were spin coated on the pre-cleaned ITO substrate at 2500 rpm for 60 s from various concentrations (10 to 30 mg/mL) to obtain various film thicknesses. These NiOₓ films were then annealed on a hot plate in air at 80 °C for 10 min. A solution of F4-TCNQ (Ossila) with various concentrations (from 0.2 to 2 mg/mL) was spin coated with the same speed and annealed at 80 °C for 30 min. The substrates were then transferred into a nitrogen-filled glovebox. The PTB7:PC70BM blend solution was prepared from the weight ratio of 1:1.5 and a total concentration of 25 mg/mL in chlorobenzene with 0.3 vol% 1,8-diiodooctane processing additive. After stirring overnight at 60 °C, the BHJ thin films (90 nm) were obtained from spin coating the solution at 1800 rpm for 120 s. The active layers were then transferred into high vacuum for overnight. ZnO nanocrystals were processed by spin coating a 5 mg/mL solution on top of the active layers at 1500 rpm for 60 s followed by annealing for 2 min at 80 °C. The top Al metal electrode (100 nm) was thermally evaporated at 1 × 10⁻⁶ Torr (1.33.10⁻⁴ Pa) pressure through a shadow mask with a device area of 0.27 cm².

### Inverted Device Structure (Figure 4 right)

1 wt.% ZnO (Avantama) was spin coated on top of the pre-cleaned ITO substrate at 5000 rpm for 60 s then annealed at 120 °C for 10 min in air. The PBDB-T-2F:IT-4F solution was prepared from a weight ratio 1:1 and a total concentration of 20 mg/mL in o-xylene. After stirring overnight at room temperature, the active layers were prepared by spin coating the ink at 2200 rpm for 2 min (without annealing). The NiOₓ HTLs were spin coated on the photoactive layer at 2500 rpm for 60 s from various concentrations (10 to 30 mg/mL) to obtain various film thicknesses. These NiOₓ films were then annealed on a hot plate in air at 80 °C for 10 min. A solution of F4-TCNQ (Ossila) with various concentrations (from 0.2 to 2 mg/mL) was spin coated with the same speed and annealed at 80 °C for 30 min. A 100 nm thick silver layer were then thermally evaporated onto the surface of the active layer at 2 × 10⁻⁶ Torr (2.66.10⁻⁴ Pa) pressure through a shadow mask.

For each device configuration, a total of six cells were measured. The current density-voltage (J-V) characteristics of the devices were measured using a Keithley 238 Source Measure Unit. Solar cell performance was measured using a Newport classe AAA 1.5 Global solar simulator (Oriel Sol3ATM model n° 94043A) with an irradiation intensity of 100 mW/cm². The light intensity was determined with a Si reference cell (Newport Company, Oriel n° 94043A) calibrated by National Renewable Energy Laboratory (NREL).

### Morphology and transparency of NiOx and Cu-NiOₓ films

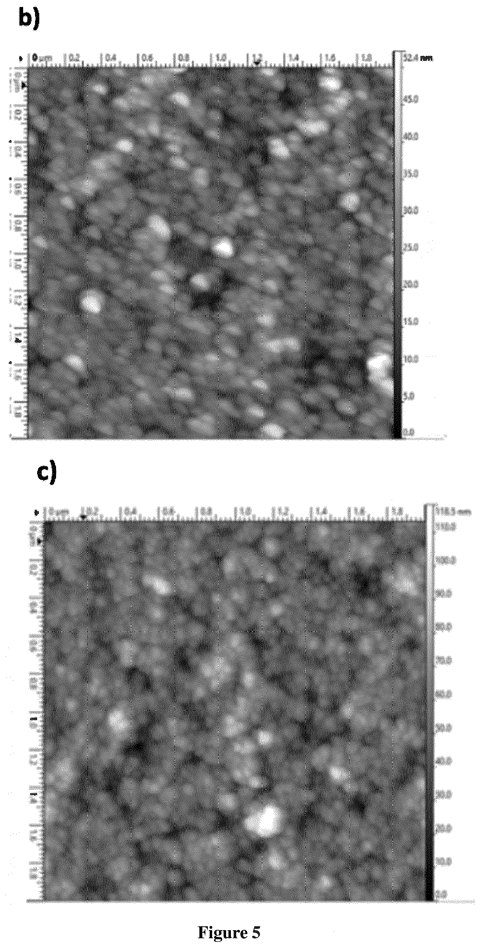

The morphology of the IPA-based Cu-NiOₓ films on ITO substrates as well as on photoactive layers based on PTB7:PC70BM blends was studied using AFM. As shown in Figure 5, closely-packed layers were observed on ITO with:
- a low surface roughness of 4 nm for the 15 nm-thick Cu-NiOₓ (12.2%) layers (Figure 5a),
- a low surface roughness of 6 nm for the 40 nm-thick Cu-NiOₓ (12.2%) layers (Figure 5b), and
- a low surface roughness of 7 nm for the 45 nm-thick Cu-NiOₓ (12.2%) layers (Figure 5c).

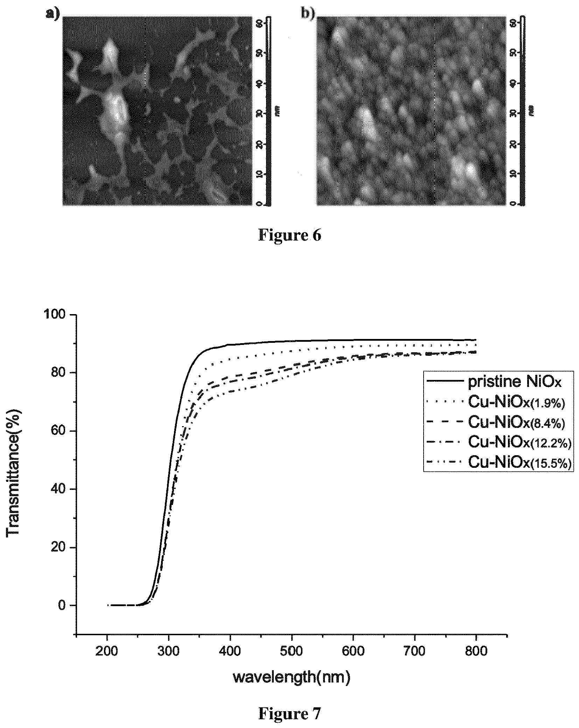

As shown in Figure 6b, the morphology of the Cu-NiOₓ layer processed on PTB7:PC70BM is also compact, pinhole-free, and with a low surface roughness of 6 nm for a 40 nm-thick Cu-NiOₓ layer. This indicates that the IPA-based Cu-NiOₓ nanoparticles are well-adapted for the solution-processing of HTL in inverted device structures.

On the contrary, a poor morphology, in particular a high RMS (Root Mean Square) roughness above 10 nm, was obtained with water-based solutions of Cu-NiOₓ nanoparticles (Figure 6a).

Transmission spectra of the casted NiOₓ films as a function of Cu-doping levels are shown in Figure 7. The 40 nm thick pristine NiOₓ films revealed a high transmission (>80%) in the visible region. As expected, the optical transmittance was slightly decreased with the increase of Cu-doping level. Despite this slight decrease in transmittance, the Cu-NiOₓ (12.2%) layers still have a percentage of transmittance higher than 78% in the visible region. This allows them to function as efficient semi-transparent interfacial layers in organic solar cells.

### OSC performances

### a) Normal Device Structure

In order to evaluate the potential of the Cu-NiOₓ (12.2%) as HTLs, OSCs have been studied in fullerene-based solar cells using a regular device structure with the following architecture: ITO/HTL/PTB7:PC70BM/ZnO/Al. F4-TCNQ was used, at various concentrations, to tune the work function of NiOx materials. The results shown in Table 1 were obtained.

**Table 1**

| F4TCNQ | Voc (mV) | Jsc (mA/cm²) | FF (%) | PCE (%) |
|---|---|---|---|---|
| 0.2 | 693 | 15 | 50 | 5.2 |
| 0.4 | 730 | 15.5 | 55.2 | 6.2 |
| 1 | 751 | 16.6 | 60 | 7.4 |
| 2 | 729 | 13.9 | 53 | 5.3 |
| PEDOT:PSS | 752 | 15.5 | 65 | 7.6 |

An optimal performance was found for 1 mg/mL F4-TCNQ leading to a PCE of 7.4%, a FF of 60%, a Voc of 751 mV and a Jsc of 16.6 mA/cm². This is comparable to that obtained using PEDOT:PSS HTLs with a PCE of 7.6%. Further increase in the F4-TCNQ concentration causes a slight decrease in the Voc and FF.

The influence of the thickness of the film on the OSC performances was also studied (Table 2).

**Table 2**

| Cu-NiOₓ (12.2%) film thickness | Voc (mV) | Jsc (mA/cm²) | FF (%) | PCE (%) |
|---|---|---|---|---|
| 15 | 741 | 16.4 | 56.3 | 6.9 |
| 40 | 751 | 16.6 | 60 | 7.4 |
| 45 | 741 | 15.2 | 59 | 6.6 |

The optimized Cu-NiOₓ (12.2%) thickness was found at 40 nm, as thinner layers of 15 nm showed less compact layer morphology, while further increase in the HTL thickness caused a slight decrease in efficiency.

### b) Inverted Device Structure

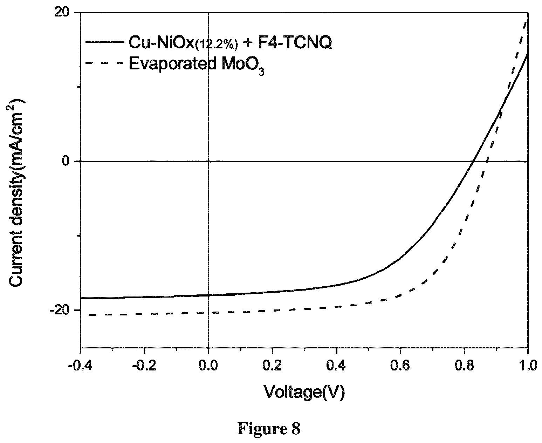

The inverted device structure ITO/ZnO/40 nm-thick PBDB-T-2F:IT-4F/HTL/Ag was studied. The J-V curves of the corresponding devices are presented in Figure 8 and the photovoltaic parameters are summarized in Table 3.

**Table 3**

| HTL | Voc (mV) | Jsc (mA/cm²) | FF (%) | PCE (%) |
|---|---|---|---|---|
| evaporated MoO₃ | 871 | 20.3 | 62 | 11 |
| 40 nm Cu-NiOx(12.2%)+F4TCNQ | 827 | 18 | 53.3 | 7.92 |
| 40 nm modified PEDOT:PSS | 700 | 19 | 46.3 | 6.3 |

As a reference cell, an efficiency of 11% was obtained using a 2 nm-thick evaporated MoO₃ with a 62% FF after post-annealing the whole device at 100 °C for 10 minutes. By replacing the evaporated HTL with a 40 nm-thick molecularly doped Cu-NiOₓ (12.2%) HTL, the optimized efficiency obtained was 7.92% with a FF of 53.3%, a Voc of 827 mV and a Jsc of 18 mA/cm². (Cu)-NiOₓ films thus appear as a competitive HTL in inverted OSCs, in comparison with known MoO₃ films.

Furthermore, NiOₓ-based HTL films (such as Cu-NiOₓ) having a thickness of several tens of nanometers can be prepared (herein 40 nm), thus giving access to more robust processes and OSCs than MoO₃ films, which needs to be 2-3 nm only.

A modified PEDOT:PSS film was also studied in the above inverted device structure. Lower performances were obtained, in comparison with (Cu)-NiOₓ films.

## Claims

1. A process for preparing an alcohol-based dispersion of NiOₓ nanoparticles, said process comprising the following steps:
(a) dispersing NiOₓ nanoparticles in a 50:50 (v/v) to 90:10 (v/v) alcohol/water mixture in the presence of methoxy-acetic acid, under ultrasonication for 1h to 3h;
(b) centrifuging the dispersion obtained in step (a) so as to recover a precipitate containing NiOₓ nanoparticles;
(c) dispersing the precipitate obtained in step (b) in alcohol and under ultrasonication for 1h to 4h;
(d) optionally filtering the dispersion obtained in step (c); and
(e) recovering an alcohol-based dispersion of NiOₓ nanoparticles;
wherein ultrasonication in each of steps (a) and (c) is carried out by means of an ultrasonication device, with a power of ultrasonication from 0.05 to 20 W/(D x S), where D is the surface of the horn of the ultrasonication device in cm² and S is the volume of the dispersion in mL.

2. The process according to claim 1, wherein said alcohol in steps (a) and (c) is an alcohol having 1 to 4 carbon atoms, preferably ethanol or isopropanol, more preferably isopropanol.

3. The process according to claim 1 or 2, wherein the weight ratio of the methoxy-acetic acid to the NiOₓ nanoparticles in step (a) is comprised between 0.5 and 2, preferably between 0.6 and 0.9.

4. The process according to any one of claims 1 to 3, wherein the mean diameter of the NiOₓ nanoparticles used in step (a) is comprised between 1 nm and 100 nm, preferably between 3 nm and 20 nm.

5. The process according to any one of claims 1 to 4, wherein the concentration of the NiOₓ nanoparticles in the alcohol/water mixture in step (a) is comprised between 0.1 mg/mL and 100 mg/mL, preferably between 5 and 40 mg/mL.

6. The process according to any one of claims 1 to 5, wherein the water content of the dispersion obtained in step (a) is removed from 95% to 99.9% in step (b).

7. The process according to any one of claims 1 to 6, wherein said alcohol/water mixture in step (a) is a 75:25 (v/v) to 85:15 (v/v) alcohol/water mixture.

8. The process according to any one of claims 1 to 7, wherein the power of ultrasonication in steps (a) and (c) is independently from 0.1 to 10 W/(D x S), preferably from 0.5 to 2 W/(D x S), where D and S are as defined in claim 1.

9. The process according to any one of claims 1 to 8, wherein the power of the ultrasonication device is comprised between 10 W and 4000 W, and/or the surface of the horn of the ultrasonication device (D) is comprised between 1 cm² and 100 cm² and/or wherein the volume of the dispersion (S) is comprised between 0.5 mL and 2000 mL.

10. The process according to any one of claims 1 to 9, wherein the NiOₓ nanoparticles comprise a dopant.

11. The process according to claim 10, wherein the dopant is tin, lithium, copper, or a mixture thereof, preferably copper.

12. The process according to claim 10 or 11, wherein the dopant concentration is comprised between 1 % at. and 40 % at., preferably between 2 % at. and 20 % at.

13. A process for preparing an inverted organic solar cell comprising:
(i) providing a multi-layer assembly comprising a photoactive layer, an electron-transport layer, and a transparent electrode, wherein said electron-transport layer is comprised between said transparent electrode and said photoactive layer;
(ii) depositing an alcohol-based dispersion of NiOₓ nanoparticles obtained by a process as defined in any one of claims 1 to 12, onto said photoactive layer, under conditions allowing to obtain a NiOₓ-based hole-transport layer;
(iii) optionally depositing at least one organic dopant layer onto said NiOₓ-based hole-transport layer; and
(iv) depositing an anode onto the assembly obtained in step (ii) or (iii), so as to obtain an inverted organic solar cell.

14. A process for preparing a normal organic solar cell comprising:
(i') depositing an alcohol-based dispersion of NiOₓ nanoparticles obtained by a process as defined in any one of claims 1 to 12, onto a transparent electrode, under conditions allowing to obtain a NiOₓ-based hole-transport layer;
(ii') optionally depositing at least one organic dopant layer onto said NiOₓ-based hole-transport layer;
(iii') depositing successively a photoactive layer and an electron-transport layer, onto the assembly obtained in step (i') or (ii'); and
(iv') depositing a cathode onto the assembly obtained in step (iii'), so as to obtain a normal organic solar cell.

15. The process according to claim 13 or 14, wherein said at least one organic dopant layer is F4TCNQ.
